(19) Europäisches Patentamt / European Patent Office / Office européen des brevets

(11) **EP 3 447 870 B1**

(12) **EUROPÄISCHE PATENTSCHRIFT**

(45) Veröffentlichungstag und Bekanntmachung des Hinweises auf die Patenterteilung:
**30.11.2022 Patentblatt 2022/48**

(21) Anmeldenummer: **17187273.2**

(22) Anmeldetag: **22.08.2017**

(51) Internationale Patentklassifikation (IPC):
**H02H 1/04** *(2006.01)* **H02H 3/28** *(2006.01)*
**G01R 19/10** *(2006.01)* **G01R 15/18** *(2006.01)*

(52) Gemeinsame Patentklassifikation (CPC):
**H02H 1/046; H02H 3/283;** G01R 15/183;
G01R 19/10

(54) **DIFFERENTIALSCHUTZVERFAHREN, DIFFERENTIALSCHUTZEINRICHTUNG UND DIFFERENTIALSCHUTZSYSTEM**

DIFFERENTIAL PROTECTION METHOD, DIFFERENTIAL PROTECTION DEVICE AND DIFFERENTIAL PROTECTION SYSTEM

PROCÉDÉ DE PROTECTION DIFFÉRENTIELLE, DISPOSITIF DE PROTECTION DIFFÉRENTIELLE ET SYSTÈME DE PROTECTION DIFFÉRENTIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.02.2019 Patentblatt 2019/09**

(73) Patentinhaber: **Siemens Aktiengesellschaft 80333 München (DE)**

(72) Erfinder:
• **Kerger, Torsten**
  **14621 Schönwalde-Glien (DE)**
• **Matussek, Robert**
  **10249 Berlin (DE)**

(56) Entgegenhaltungen:
**EP-A2- 0 688 078      WO-A1-2008/145694
DE-A1- 19 802 831      DE-A1- 19 928 192
US-B1- 6 501 631**

**Beschreibung**

Die Erfindung betrifft ein Differentialschutzverfahren zum Überwachen einer Leitung eines elektrischen Energieversorgungsnetzes, bei dem an den Enden der Leitung mit induktiven Stromwandlern Stromsignale erzeugt werden, die zu einem an dem jeweiligen Ende fließenden Strom proportional sind, für jedes Ende mit Messeinrichtungen aus dem jeweiligen Stromsignal Strommesswerte gebildet werden, die einen Verlauf des an dem jeweiligen Ende fließenden Stroms angeben, aus den Strommesswerten für jedes Ende ein jeweiliger Ladungswert bestimmt wird, die Ladungswerte aller Enden vorzeichenrichtig unter Bildung einer Ladungssumme aufsummiert werden, und ein einen internen Fehler auf der Leitung angebendes Fehlersignal erzeugt wird, wenn die Ladungssumme einen Ladungs-Schwellenwert übersteigt. Die Erfindung betrifft auch ein Differentialschutzgerät und ein Differentialschutzsystem.

Zur Überwachung von Hoch- und Mittelspannungsleitungen, z.B. Freileitungen oder Kabeln, elektrischer Energieversorgungsnetze wird oft ein Strom-Differentialschutzverfahren (nachfolgend der Einfachheit halber als "Differentialschutzverfahren" bezeichnet) eingesetzt. Dabei wird der an den Enden der überwachten Leitung fließende Strom unter Bildung von Strommesswerten erfasst und einer Differentialschutzeinrichtung zugeführt. Die Differentialschutzeinrichtung prüft anhand der erfassten Strommesswerte, ob ein zulässiger Betriebszustand oder ein Fehler vorliegt.

Hierzu können beispielsweise durch vektorielle Addition und anschließende Betragsbildung aus mit den Strommesswerten gebildeten Stromzeigermesswerten Differenzstromwerte bestimmt werden. Im fehlerfreien Fall liegen die Differenzstromwerte in einem Bereich nahe Null, da hierbei - vereinfacht gesprochen - der in die Komponente hinein fließende Strom vollständig auch wieder aus ihr heraus fließt. Ergeben sich hingegen Differenzstromwerte, die einen von Null verschiedenen Schwellenwert überschreiten, so lassen diese auf einen fehlerbehafteten Betriebszustand, z.B. einen inneren Fehler, schließen. Man unterscheidet zwischen inneren Fehlern und äußeren Fehlern. Innere Fehler liegen innerhalb des Schutzbereiches zwischen den Stromwandlern und müssen abgeschaltet werden. Äußere Fehler liegen außerhalb des zu schützenden Bereiches und dürfen nicht zu einer Abschaltung führen.

Im Fall eines inneren Fehlers muss der vorliegende Fehlerstrom durch Öffnen von die Leitung begrenzenden Schalteinrichtungen, z.B. Leistungsschaltern, unterbrochen werden. Hierfür erzeugt die Differentialschutzeinrichtung ein entsprechendes Fehlersignal, wodurch die Erzeugung eines Schaltsignals für die jeweilige Schalteinrichtung veranlasst werden kann.

Eine Ausführungsform des Differentialschutzes ist der Ladungsdifferentialschutz. Hierbei wird nicht der Strom als Zeigerwert summiert. Stattdessen wird das zeitliche Integral des Stroms, die Ladung, benutzt, um die Summierung durchzuführen. Die zweite Kirchhoffsche Regel (Knotenpunktsatz) gilt auch für Ladungsmesswerte. Ein Integrationsintervall von ¼ Netzperiode wird benutzt, um aus dem zeitlichen Verlauf des Stroms i(t) Ladungswerte Q(t) gemäß

$$Q(t) = \int_{t_1}^{t_2} i(t)\,dt$$

zu gewinnen. Im Unterschied zu Zeigerwerten ist die Ladung ein skalarer Wert und somit unabhängig von der Netzfrequenz. Ein Beispiel eines Ladungsdifferentialschutzsystems ist z.B. aus der deutschen Offenlegungsschrift DE 19959776 A1 bekannt.

Bei einer Energieübertragungsleitung liegen die Leitungsenden üblicherweise weit (bis zu einigen Hundert Kilometern) auseinander, so dass die Strommesswerte über eine längere Strecke übertragen werden müssen. In einem solchen Fall ist üblicherweise an jedem der Enden der Leitung eine separate Differentialschutzeinrichtung angeordnet, die den jeweiligen Differenzstromwert aus den eigenen (lokal erfassten) Strommesswerten und den vom anderen Ende der Leitung empfangenen Strommesswerten bildet. Bei einer Leitung mit mehreren Enden, z.B. einer verzweigten Leitung, sind zudem Strommesswerte von jedem der Enden erforderlich, um das Differentialschutzverfahren korrekt durchführen zu können. Dazu müssen die an den jeweiligen Messstellen lokal erfassten Strommesswerte zwischen den einzelnen Differentialschutzgeräten übertragen werden.

Zur Beurteilung der Betriebssituation der Leitung sind folglich Strommesswerte von zumindest zwei unterschiedlichen Messstellen an den jeweiligen Enden der überwachten Leitung erforderlich.

Bei bestehenden Differentialschutzsystemen werden die Strommesswerte häufig über eine festverdrahtete Punkt-zu-Punkt-Verbindung (z.B. Kupfer- oder Glasfaserleitungen) übertragen, wodurch eine deterministische Übertragung erreicht wird, d.h., die Übertragungszeit der Messwerte ist hauptsächlich abhängig von der Übertragungsstrecke und der Übertragungsart sowie im Wesentlichen konstant. Bei jüngeren Differentialschutzsystemen geht man mittlerweile dazu über, die Strommesswerte anstelle über eine Festverdrahtung über ein Kommunikationsnetzwerk, z.B. ein Telekommunikationsnetzwerk oder ein auf dem IP-Protokoll basierendes Datenkommunikationsnetzwerk, zu übertragen. Dies hat den Vorteil einer kostengünstigeren Kommunikationsinfrastruktur. Außerdem sind Kommunikationsnetzwerke oftmals bereits in der Nähe elektrischer Primärkomponenten, z.B. zwischen sogenannten Unterstationen eines Energieversorgungsnetzes, vorhanden und können ohne zusätzliche Kosten für die Übermittlung der Strommesswerte genutzt werden.

Zur Erfassung der Strommesswerte werden häufig konventionelle Stromwandler eingesetzt, um die vergleichsweise hohen elektrischen Wechselströme in niedrigere elektrische Wechselströme umzusetzen, so dass sie von den elektrischen Differentialschutzgeräten verarbeitet werden können. Konventionelle elektrische Stromwandler umfassen hierbei einen Wandlerkern aus einem magnetisierbaren Material (beispielsweise Eisenlegierungen oder Stahl), der in magnetischer Wechselwirkung mit einem Primärleiter und einem Sekundärleiter steht. Häufig wird ein solcher Kern als sogenannter Ringkern ausgebildet, der einen Ring um den Primärleiter bildet. Der Sekundärleiter ist in diesem Fall mit einer gewissen Anzahl von Wicklungen um den Wandlerkern gewunden.

Der Primärleiter wird von dem vergleichsweise hohen Wechselstrom durchflossen. Dieser induziert ein Magnetfeld in dem Wandlerkern, das wiederum in dem Sekundärleiter einen entsprechend des Wandlerübersetzungsverhältnisses geringeren Wechselstrom induziert, dessen Höhe üblicherweise proportional zur Höhe des Primärstroms ist.

Aufgrund der magnetischen Eigenschaften des Wandlerkerns kann jedoch bei primärseitigen hohen Strömen oder starken Gleichstromanteilen im Wechselstrom eine sogenannte Wandlersättigung eintreten, wodurch der Verlauf des Sekundärstromes nicht mehr proportional zum Verlauf des Primärstromes ist und die auf der Sekundärseite des Stromwandlers erfassten Messwerte somit durch die Stromwandlersättigung gestört sind.

Tritt Stromwandlersättigung an einem oder mehreren der beteiligten Leitungsenden auf, wird die Summe der Primärströme nicht proportional auf die Sekundärseiten hin zum Schutzgerät übertragen. Die Messung des Differentialschutzes wird erheblich gestört, so dass unerwünschte Überfunktionen, z.B. Fehlauslösungen eines Leistungsschalters bei äußeren Fehlern, oder ein Nichtansprechen bei inneren Fehlern auftreten können. Solche Fehlauslösungen sind für Betreiber des elektrischen Energieversorgungsnetzes aufgrund der damit verbundenen Stromausfälle mit hohen Kosten verbunden. Im Falle unerwünschten Nichtansprechens können Beschädigungen der Primärtechnik auftreten.

In Abhängigkeit des Zeitpunktes, zu dem die Sättigung des Stromwandlers nach einer sättigungsfreien Zeit einsetzt, kann ein Differentialschutzsystem vorher den Fehler als inneren Fehler oder äußeren Fehler identifizieren. Gelingt dies bis zum Eintritt der Sättigung nicht, so machen die nun auftretenden Messfehler es schwer möglich, die Trennung zwischen innerem und äußerem Fehler vorzunehmen.

Um Fehlfunktionen von elektrischen Geräten zu vermeiden, die eine Weiterverarbeitung der Messwerte vornehmen, werden Verfahren eingesetzt, durch Stromwandlersättigung gestörte Sekundärstromverläufe automatisch zu erkennen und eine entsprechende Korrektur der gestörten Werte vorzunehmen. Ein Verfahren der oben angegebenen Art ist beispielsweise aus der US-Patentschrift US 7,103,485 B2 bekannt. Bei dem bekannten Verfahren werden Messwerte eines Sekundärstromverlaufs eines Stromwandlers erfasst und auf eine möglicherweise vorliegende Sättigung überprüft. Wenn eine Stromwandlersättigung erkannt wird, wird zum Startzeitpunkt der Stromwandlersättigung ein Magnetisierungsstrom berechnet, anhand dessen ein zum Startzeitpunkt vorliegender magnetischer Fluss in dem Wandlerkern bestimmt wird. Unter Verwendung für den speziellen Stromwandler charakteristischer Kennlinien, die einen Zusammenhang zwischen dem magnetischen Fluss und dem Sekundärstrom angeben, werden die durch Sättigung des Stromwandlers gestörten Messwerte nach dem Startzeitpunkt korrigiert, um einen korrekten Verlauf der Messwerte des Sekundärstromes durch Kompensation der Störung durch Stromwandlersättigung zu erhalten. Allerdings sind die benötigten, für den entsprechenden Stromwandler charakteristischen Kennlinien häufig nur schwer verfügbar oder sogar überhaupt nicht vorhanden und müssen erst durch aufwendige Messungen erzeugt werden.

Aus der WO 2008/145694 A1 ist es zudem bekannt, den durch Stromwandlersättigung gestörten Stromverlauf unter Nutzung vergangener Strommesswerte zu korrigieren und den erwarteten Stromverlauf zu rekonstruieren. Ein ähnliches Verfahren ist aus der DE 199 28 192 A1 bekannt.

Außerdem ist es bekannt, eine Stabilisierung des Differentialschutzes durchzuführen, indem der für die Bewertung der Ladungssumme herangezogene Ladungs-Schwellenwert entsprechend erhöht wird. Alternativ kann bei vorliegender Wandlersättigung die Differentialschutzerkennung auch komplett blockiert werden, um Fehlauslösungen zu vermeiden. Beide Varianten haben Nachteile, die sich insbesondere bei der Unterscheidung zwischen inneren (abzuschaltenden) und äußeren (nicht abzuschaltenden) Fehlern bemerkbar machen. Eine Stabilisierung des Messsystems führt zu einer verminderten Empfindlichkeit bei inneren Fehlern, die hierdurch unter Umständen nicht mehr erkannt werden können. Die Blockierung des Messsystems führt zur Nichterkennung von inneren Fehlern bzw. von Folgefehlern.

Weitere Schutzverfahren, bei denen Maßnahmen zur Verringerung des Einflusses von Wandlersättigung getroffen werden, sind aus der EP 0688078 A2 oder der US 6 501 631 B1 bekannt.

Der Erfindung liegt die Aufgabe zugrunde, einen Leitungsdifferentialschutz auch bei Stromwandlersättigung in einfacher Weise möglichst zuverlässig betreiben zu können.

Diese Aufgabe wird durch ein Verfahren der eingangs genannten Art gelöst, bei dem bei vorliegender Wandlersättigung eines Stromwandlers mit der entsprechenden Messeinrichtung ein Ladungs-Schätzwert ermittelt wird und der Ladungs-Schätzwert anstelle des durch Wandlersättigung verfälschten Ladungswertes zur Bildung der Ladungssumme verwendet wird.

Ein Vorteil des erfindungsgemäßen Verfahrens besteht darin, dass, ohne die Notwendigkeit einer signifikanten Stabilisierung oder einer Blockierung des Differentialschutzes Fehler auf der Leitung sicher erkannt werden können, da anstelle des durch Wandlersättigung verfälschten Ladungswertes ein Ladungs-Schätzwert verwendet wird, dessen Höhe ungefähr der Höhe des im Fall fehlender Wandlersättigung ermittelten Ladungswertes entspricht. Hierdurch kann der durch Wandlersättigung entstehende Messfehler weitgehend kompensiert werden.

Eine vorteilhafte Ausführungsform des erfindungsgemäßen Verfahrens sieht vor, dass zur Bildung des jeweiligen Ladungswertes während eines vorgegebenen Zeitintervalls ein zeitliches Integral über die Strommesswerte des jeweiligen Endes der Leitung gebildet wird.

Durch Integration bzw. Aufsummierung der einzelnen Strommesswerte lässt sich die Ladung als Fläche unter der Kurve eines Strom-Zeit-Diagramms bestimmen. Beispielsweise kann als Zeitintervall eine Viertelperiode oder eine halbe Periode der Netzfrequenz verwendet werden.

Gemäß einer vorteilhaften Ausführungsform des erfindungsgemäßen Verfahrens kann vorgesehen sein, dass der Ladungs-Schätzwert unter Verwendung zumindest eines zum Eintrittszeitpunkt der Wandlersättigung vorliegenden Strommesswertes ermittelt wird.

Auf diese Weise kann der Ladungs-Schätzwert vergleichsweise einfach und unter Verwendung ohnehin vorhandener Messwerte ermittelt werden.

Konkret kann in diesem Zusammenhang vorgesehen sein, dass zur Ermittlung des Ladungs-Schätzwertes eine zum einen durch den

Strommesswert zum Eintrittszeitpunkt der Wandlersättigung und zum anderen durch den letzten Nulldurchgang des Stromverlaufs gehende Gerade bestimmt wird, und der Ladungs-Schätzwert als innerhalb des Zeitintervalls zwischen der Geraden und der Nulllinie liegende Fläche bestimmt wird.

Auf diese Weise kann durch relativ einfache Berechnungen und unter Verwendung lediglich zweier Punkte im Stromverlauf der Ladungs-Schätzwert bestimmt werden. Diese Abschätzung eignet sich insbesondere für relativ früh einsetzende Sättigungseffekte, bei denen die sättigungsfreie Zeit entsprechend kurz ist.

Alternativ kann auch vorgesehen sein, dass zur Ermittlung des Ladungs-Schätzwertes ein Rechteck gebildet wird, dessen eine Seite durch den Strommesswert zum Eintrittszeitpunkt der Wandlersättigung und dessen andere Seite durch die Dauer des Zeitintervalls bestimmt wird, und der Ladungs-Schätzwert als Fläche des Rechtecks bestimmt wird.

Auf diese Weise kann wiederum unter Verwendung weniger Punkte im Stromverlauf ein Ladungs-Schätzwert ermittelt werden. Diese Vorgehensweise eignet sich besonders für relativ spät einsetzende Sättigungseffekte, bei denen der Stromverlauf bereits nah am Maximum der im Wesentlichen sinusförmigen Stromkurve angekommen ist.

Eine weitere vorteilhafte Ausführungsform des erfindungsgemäße Verfahrens sieht zudem vor, dass zur Erkennung des Eintrittszeitpunkts der Wandlersättigung ein Differenzwert zwischen einem aktuellen Strommesswert und einem Vorhersagewert bestimmt wird, wobei der Vorhersagewert einen erwarteten Verlauf des Stromes angibt, und der Eintrittszeitpunkt dann erkannt wird, wenn der Differenzwert einen Sättigungs-Schwellenwert überschreitet.

Hierdurch kann ohne besonders großen Rechenaufwand eine einsetzende Wandlersättigung erkannt werden. Der Vorhersagewert kann beispielsweise aus dem bisherigen Verlauf des Stroms abgeleitet werden und z.B. mit dem Strommesswert eine Periodendauer zuvor gleichgesetzt werden. Zusätzlich können auch Gleichstromanteile und abklingende Effekte bei der Bildung des Vorhersagewertes berücksichtigt werden.

Um die Tatsache zu berücksichtigen, dass der Ladungs-Schätzwert nicht exakt dem Ladungswert entspricht, der ohne Wandlersättigung ermittelt worden wäre, kann gemäß einer weiteren vorteilhaften Ausführungsform des erfindungsgemäßen Verfahrens vorgesehen sein, dass bei vorliegender Wandlersättigung der Ladungs-Schwellenwert zeitweise erhöht wird.

Diese Form der Stabilisierung kann jedoch deutlich geringer ausfallen als eine Stabilisierung, die - ohne Bildung eines Ladungs-Schätzwertes - zur Kompensation der Wandlersättigung hätte eingesetzt werden müssen. Der Ladungs-Schwellenwert kann in diesem Zusammenhang beispielsweise ein einzelner skalarer Wert sein, der mit dem Ladungswert verglichen wird. Alternativ kann auch eine Kennlinie in einem Auslösediagramm verwendet werden, die für Paare von Ladungswerten und Stabilisierungswerten einen Auslösebereich von einem Normalbereich trennt. Durch entsprechende Verschiebung der Kennlinie kann eine zeitweise Erhöhung des Ladungs-Schwellenwertes erreicht werden.

Die oben genannte Aufgabe wird auch durch eine Differentialschutzeinrichtung zum Überwachen einer Leitung eines elektrischen Energieversorgungsnetzes gelöst mit einer Messeinrichtung, die zum Erfassen eines an einem Ende der Leitung erzeugten Stromsignals und zur Bildung von Strommesswerten, die einen Verlauf eines an dem jeweiligen Ende fließenden Stroms angeben, eingerichtet ist, wobei das Stromsignal mit einem induktiven Stromwandler proportional zu einem an dem Ende fließenden Strom erzeugt worden ist, und mit einer Auswertungseinrichtung, die dazu eingerichtet ist, aus den Strommesswerten einen Ladungswert zu bestimmen, die Ladungswerte mit einem Ladungsmesswert mindestens einer anderen Differentialschutzeinrichtung vorzeichenrichtig unter Bildung einer Ladungssumme aufzusummieren und ein einen internen Fehler auf der Leitung angebendes Fehlersignal zu erzeugen, wenn die Ladungssumme einen Ladungs-Schwellenwert übersteigt.

Erfindungsgemäß ist vorgesehen, dass die Auswertungseinrichtung dazu eingerichtet ist, bei vorliegender Wandlersättigung des Stromwandlers einen Ladungs-Schätzwert zu ermitteln und diesen anstelle des durch Wandlersättigung verfälschten Ladungswertes zur Bildung der Ladungssumme zu verwenden.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Die oben genannte Aufgabe wird schließlich auch durch ein Differentialschutzsystem zum Überwachen einer Leitung eines elektrischen Energieversorgungsnetzes, wobei die Leitung mindestens zwei Enden aufweist, gelöst.

Erfindungsgemäß ist an jedem Ende eine Differentialschutzeinrichtung gemäß Anspruch 8 angeordnet.

Hinsichtlich des erfindungsgemäßen Systems gelten ebenfalls alle zu dem erfindungsgemäßen Verfahren bzw. der erfindungsgemäßen Einrichtung voranstehend und nachfolgend gemachten Ausführungen und umgekehrt in entsprechender Weise, insbesondere ist das erfindungsgemäße System zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Systems wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1    ein Differentialschutzsystem im Fall einer durch Wandlersättigung gestörten Messung bei einem äußeren Fehler;

Figur 2    ein Differentialschutzsystem im Fall einer durch Wandlersättigung gestörten Messung bei einem inneren Fehler;

Figur 3    ein erstes Beispiel der Bildung eines Ladungs-Schätzwertes;

Figur 4    ein zweites Beispiel der Bildung eines Ladungs-Schätzwertes;

Figur 5    ein Differentialschutzsystem im Fall einer durch Wandlersättigung gestörten Messung bei einem äußeren Fehler mit Kompensation durch Verwendung eines Ladungs-Schätzwertes; und

Figur 6    ein Differentialschutzsystem im Fall einer durch Wandlersättigung gestörten Messung bei einem inneren Fehler mit Kompensation durch Verwendung eines Ladungs-Schätzwertes.

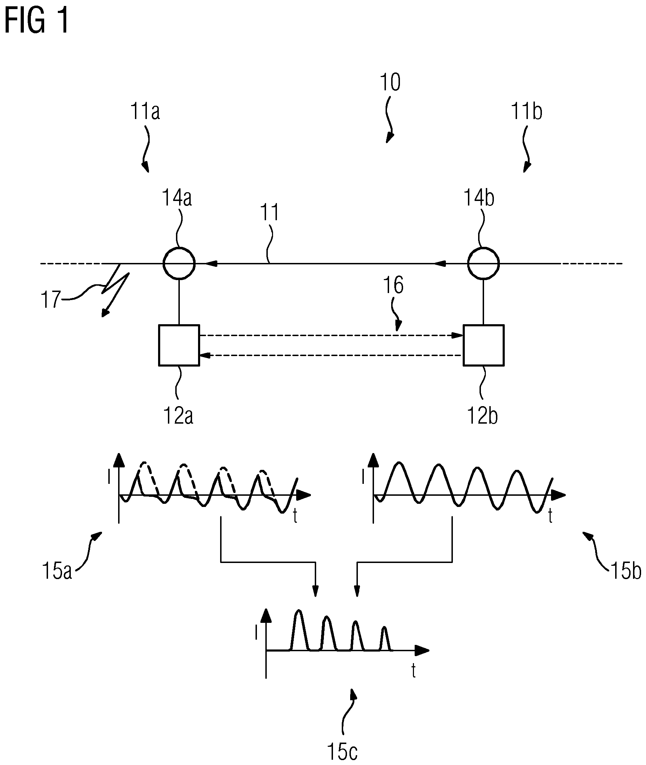

Figur 1 zeigt einen Teil 10 eines im Weiteren nicht näher dargestellten elektrischen Energieversorgungsnetzes. Der Teil 10 umfasst eine elektrische Leitung 11, die beispielsweise dreiphasig und als Freileitung oder als Kabel ausgebildet sein kann. Die Leitung 11 wird an ihrem ersten Ende 11a mittels einer ersten Differentialschutzeinrichtung 12a und an ihrem zweiten Ende 11b mittels einer zweiten Differentialschutzeinrichtung 12b hinsichtlich auf der Leitung 11 auftretender Fehler, z.B. Kurzschlüsse, überwacht. Hierfür werden für jede Phase der Leitung 11 an dem ersten Ende 11a der Leitung 11 mit einem Stromwandler 14a und an einer zweiten Messstelle an dem zweiten Ende 11b mit einem Stromwandler 14b Stromsignale erfasst und einer jeweiligen Messeinrichtung der entsprechenden Differentialschutzeinrichtung 12a, 12b zugeführt. Aus den analogen Stromsignalen werden Strommesswerte erzeugt. Die Erzeugung der Strommesswerte inklusive einer A/D-Wandlung kann z.B. in der Messeinrichtung der jeweiligen Differentialschutzeinrichtung 12a, 12b oder in einem geeigneten Messgerät, z.B. einer Remote Terminal Unit (RTU) oder einer Merging Unit, erfolgen. Letztlich werden die erzeugten Strommesswerte einer Auswerteeinrichtung, z.B. einer CPU oder einem Signalprozessor, der jeweiligen Differentialschutzeinrichtung 12a, 12b zugeführt.

Aus den Strommesswerten kann in der Auswerteeinrichtung der jeweiligen Differentialschutzeinrichtung 12a, 12b durch zeitliche Integration oder Summation der Strommesswerte über ein vorgegebenes Zeitintervall, z.B. ¼ Periode oder ½ Periode der Netzfrequenz, ein jeweiliger Ladungswert gebildet werden, der phasenweise die während des Zeitintervalls an dem jeweiligen Leitungsende geflossene Ladungsmenge angibt.

Die Differentialschutzeinrichtungen 12a bzw. 12b sind durch eine in Figur 1 nur schematisch angedeutete Kommunikationsverbindung 16 miteinander verbunden, bei der es sich z.B. um eine festverdrahtete Signalleitung, ein Telekommunikationsnetz oder ein IP-basiertes Kommunikationsnetz handeln kann. Allerdings kann auch jede weitere Kommunikationsverbindung beliebiger Art zur Verbindung der Differentialschutzeinrichtungen 12a und 12b eingesetzt werden. Über diese Kommunikationsverbindung 16 können der jeweiligen Differentialschutzeinrichtung 12a bzw. 12b die Ladungswerte vom jeweils anderen Ende 11a, 11b der Leitung 11 zur Verfügung gestellt werden, das heißt, es können in jeder Differentialschutzeinrichtung 12a bzw. 12b für jede Phase der Leitung 11 jeweils an beiden Enden 11a und 11b bestimmte Ladungswerte miteinander verglichen werden.

Anhand der in beiden Differentialschutzeinrichtungen 12a und 12b verfügbaren Ladungswerte von beiden Enden 11a und 11b der Leitung 11 kann in einer oder beiden Differentialschutzeinrichtungen 12a bzw. 12b mittels der Auswerteeinrichtung durch vorzeichenrichtige Addition der Ladungswerte und anschließende Betragsbildung pro Phase ein Summenladungswert gebildet und mit einem Ladungs-Schwellenwert verglichen werden.

Bei fehlerfreier Leitung 11 ist die pro Phase in die Leitung 11 eintretende Ladungsmenge gleich der aus der Leitung 11 austretenden Ladungsmenge, so dass sich bei vorzeichenrichtiger Addition der Ladungswerte ein Wert mit dem Betrag von etwa Null ergeben müsste.

Überschreitet für eine bestimmte Phase der Summenladungswert den vorgegebenen Ladungs-Schwellenwert, so weist dies auf einen inneren Fehler hinsichtlich der betreffenden Phase der Leitung 11 hin, bei dem es sich beispielsweise um einen Kurzschluss mit Erdbeteiligung oder einen zwei- oder mehrpoligen Kurzschluss, d.h. einen Kurzschluss zwischen zwei oder mehr Phasen der Leitung 11, handeln kann. Für diejenige Phase, bei der der Fehler erkannt worden ist, erzeugen die Differentialschutzeinrichtungen 12a und 12b ein Fehlersignal, wodurch die Abgabe eines Auslösesignals über Steuerleitungen an in der Figur 1 nicht gezeigte phasenselektiv schaltbare Leistungsschalter bewirkt wird. Das Auslösesignal veranlasst den entsprechenden phasenbezogenen Leistungsschalter zum Öffnen seiner Schaltkontakte, so dass die von dem Fehler betroffene Phase vom restlichen Energieversorgungsnetz abgetrennt wird. In Figur 1 ist beispielhaft ein äußerer Fehler 17 gezeigt. Dieser liegt nicht auf der überwachten Leitung 11 und soll daher nicht von den Differentialschutzeinrichtungen 12a und 12b abgeschaltet werden. Dies wird beim Ladungsdifferentialschutz dadurch erreicht, dass die Ladungssumme unterhalb des betrachteten Ladungs-Schwellenwertes liegt, da die in die Leitung 11 hineinfließende Ladungsmenge der aus der Leitung 11 hinausfließenden Ladungsmenge entspricht.

Für den Fall, dass mindestens einer der Stromwandler 14a, 14b in einen Sättigungszustand fällt, kann das Stromsignal jedoch nicht mehr korrekt aus dem primärseitig auftretenden Strom erzeugt werden, so dass bei der Ermittlung des entsprechenden Ladungswertes ein signifikanter Fehler auftritt.

In Figur 1 sei beispielhaft angenommen, dass die Messung mit Stromwandler 14a durch Sättigung beeinträchtigt ist. Ein entsprechender Verlauf des erzeugten Stromsignals ist in Diagramm 15a gezeigt. In diesem Diagramm 15a ist der Verlauf des sekundärseitig vom Stromwandler 14a erzeugten Stromsignals in durchgezogener Linie gezeigt. Zum Vergleich ist in gestrichelter Linie der Verlauf des Stromsignals ohne Wandlersättigung angegeben.

In Diagramm 15b ist der Verlauf des sekundärseitig vom Stromwandler 14b abgegebenen Stromsignals gezeigt. Dieser Stromwandler 14b ist nicht durch Wandlersättigung beeinträchtigt, so dass der erzeugte Stromverlauf den primärseitig anliegenden Strom korrekt wiedergibt.

In Diagramm 15c ist zur Veranschaulichung des Fehlers, der durch die verfälschte Messung des Stromwandlers 14a entsteht, der Verlauf der Differenz der beiden Stromverläufe dargestellt. Für den hier vorliegenden Fall eines äußeren Fehlers erkennt man, dass ein signifikanter Differenzstrom auftritt. In entsprechender Weise ist durch die verfälschte Messung des Stromwandlers 14a der aus den Strommesswerten erzeugte Ladungswert fehlerbehaftet, so dass bei einem Vergleich der Ladungssumme mit dem Ladungs-Schwellenwert ein innerer Fehler erkannt wird. Dadurch wird eine ungewollte Abschaltung der Leitung verursacht.

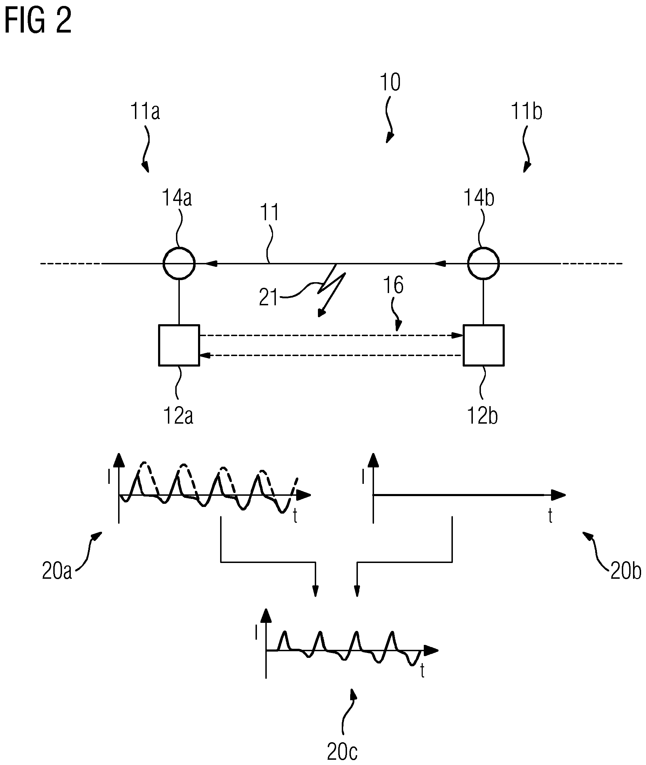

Figur 2 zeigt das Differentialschutzsystem der Figur 1 im Fall eines inneren Fehlers 21. Dieser muss durch die Differentialschutzeinrichtungen 12a, 12b als solcher erkannt und abgeschaltet werden. Bei einem inneren Fehler entsprechen sich die an beiden Leitungsenden fließenden Ströme - und entsprechend auch die Ladungsmengen - nicht, da auch durch die Fehlerstelle ein Fehlerstrom fließt. Durch entsprechenden Vergleich der für die Enden bestimmten Ladungsmengen lässt sich somit ein innerer Fehler erkennen. Im Falle vorliegender Wandlersättigung ist wieder zumindest ein Stromsignal gestört. In Figur 2 ist dies beispielhaft in Diagramm 20a für Stromwandler 14a gezeigt. Diagramm 20b zeigt das mit Stromwandler 14b erzeugte Stromsignal. Da am Ende 11b der Leitung bei einer einseitigen Speisung aufgrund des Fehlers 21 kein Strom fließt, wird hier ein Verlauf mit dem Wert Null erfasst. In Diagramm 20c erkennt man den Verlauf der Stromdifferenz. Aufgrund der Sättigung des Stromwandlers 14a sind die Stromspitzen signifikant niedriger ausgebildet als dies bei fehlender Wandlersättigung der Fall gewesen wäre. Entsprechendes gilt für die mit den Stromsignalen der Wandler 14a, 14b gebildeten Ladungswerte. Daher wird beim Vergleich der Ladungssumme mit einem Ladungs-Schwellenwert im ungünstigen Fall ein innerer Fehler nicht erkannt und abgeschaltet.

Um dennoch auch bei vorliegender Wandlersättigung eine zuverlässige Entscheidung über das Vorliegen innerer oder äußerer Fehler treffen zu können, wird bei der Bildung des Ladungswertes die durch Wandlersättigung eintretende Verfälschung des Stromsignals durch Bildung von Ladungs-Schätzwerten kompensiert.

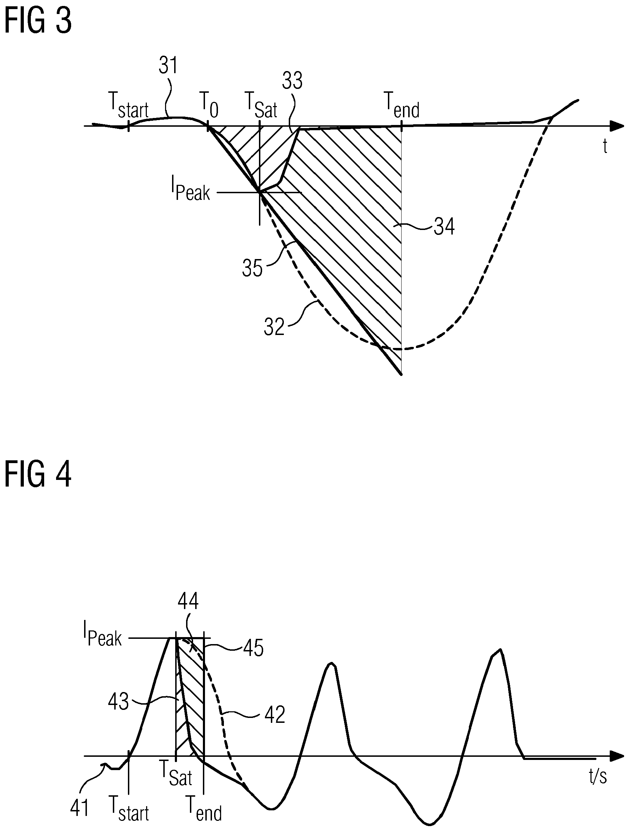

Ein Ausführungsbeispiel zur Bildung eines Ladungs-Schätzwertes ist in Figur 3 dargestellt. Figur 3 zeigt einen Verlauf 31 des sekundärseitig von einem Stromwandler abgegebenen Stromsignals. Zum Zeitpunkt $T_{Sat}$ tritt Wandlersättigung ein und der weitere Verlauf des Stromsignals weicht signifikant vom erwarteten Verlauf 32 ab, der in Figur 3 als punktierte Linie gezeigt ist. Durch Integration der durch den Stromverlauf 31 vorgegebenen Strommesswerte würde sich als Ladungswert der Wert der in Figur 3 dargestellten Fläche 33 ergeben, der signifikant kleiner ist als die tatsächlich geflossene Ladungsmenge.

Daher wird die geflossene Ladungsmenge mittels eines Ladungs-Schätzwertes abgeschätzt. Im Fall der Figur 3 wird der Ladungs-Schätzwert unter Verwendung nur weniger Punkte auf dem Verlauf 31 des gemessenen Stromsignals erzeugt. Zum einen wird der Zeitpunkt $T_{Sat}$ des Eintretens der Wandlersättigung benötigt. Dieser kann beispielsweise dadurch erkannt werden, dass zu diesem Zeitpunkt der tatsächliche Stromverlauf 31 vom erwarteten Stromverlauf 32 erstmalig deutlich abweicht. Der erwartete Stromverlauf 32 ergibt sich beispielsweise aus dem Verhalten des Stromverlaufs eine ganze Anzahl von Perioden zuvor, wobei ggf. Gleichstromanteile und/oder abklingende Glieder berücksichtigt werden können. Zum Zeitpunkt $T_{Sat}$ wird der dort vorliegende Spitzenstrom $I_{Peak}$ ermittelt. Außerdem wird der Zeitpunkt $T_0$ des letzten Nulldurchgangs des Stromverlaufs 31 benötigt. Dieser kann aus der Messung - ggf. durch Interpolation - entnommen werden. Unter Verwendung dieser beiden Punkte auf dem Verlauf 31 kann eine Gerade 35 mit der Geradengleichung

$$ I_{est}(t) = \Delta I \cdot t + I_0 = \frac{I_{Peak}}{T_{Sat} - T_0} \cdot t + I_0 $$

bestimmt werden. Diese Gerade 35 besitzt ungefähr die Steigung des Verlaufs 31 zum Zeitpunkt $T_{Sat}$ des Eintritts der Stromwandlersättigung. Der nun berechenbare Wert $I_{est}(T)$ beschreibt einen geschätzten Strom (est = estimated) auf der Geraden 35, der durch die Geradengleichung gewonnen wird. Zur Bildung des Ladungs-Schätzwertes $Q_{est}$ im Zeitbereich $T_{start}$ bis $T_{end}$ findet eine Integration der durch die Geradengleichung bestimmbaren geschätzten Strommesswerte $I_{est}(t)$ statt:

$$ Q_{est}(t) = \int_{T_{start}}^{T_{end}} I_{est}(t)\, dt = 0{,}5 \cdot \Delta I \cdot \left( T_{end}^2 - T_{start}^2 \right) $$

Anschaulich gesprochen wird der Wert der innerhalb des Zeitintervalls $T_{end}$-$T_{start}$ geflossenen Ladungsmenge somit als die Summe der beiden Flächenanteile 33 und 34 bestimmt. Man erkennt, dass durch die Verwendung der Geraden der Ladungs-Schätzwert relativ gut an diejenige Ladungsmenge angepasst werden kann, die ohne Wandlersättigung bestimmt worden wäre.

Diese Vorgehensweise der Bildung eines Ladungs-Schätzwertes eignet sich insbesondere in Fällen, in denen die Wandlersättigung bereits recht früh nach dem Nulldurchgang des Stromverlaufs eintritt.

Eine Alternative zur Bestimmung eines Ladungs-Schätzwertes ist in Figur 4 dargestellt. Dabei wird die Ladungsmenge mittels eines Rechtecks 45 abgeschätzt. Hierzu wird wiederum der Spitzenwert $I_{Peak}$ des Stromverlaufs 41 zum Zeitpunkt $T_{Sat}$ des Eintritts der Sättigung benötigt. Dieser Zeitpunkt kann wieder dort erkannt werden, wo die erste signifikante Abweichung zwischen dem gemessenen Stromverlauf 41 und dem erwarteten Verlauf 42 auftritt. Zu diesem Zeitpunkt wird ein Rechteck 45 aufgespannt, dessen eine Kantenlänge der Höhe des Spitzenstroms $I_{Peak}$ entspricht. Die andere Kantenlänge wird durch die Dauer des Zeitintervalls $T_{end}$-$T_{sat}$ bestimmt. Man erkennt, dass ohne Kompensation der Stromwandlersättigung die Ladungsmenge als Fläche 43 mit einem deutlich zu geringen Wert bestimmt worden wäre, während die Summe der Flächen 43 und 44 sich der tatsächlichen Ladungsmenge deutlich annähert.

Da durch die Bildung des Ladungs-Schätzwertes in die Bildung der Ladungssumme jeweils Werte eingehen, die zwar dem tatsächlichen Wert angenähert sind, diesen aber nicht vollständig korrekt annehmen, ist vorteilhaft in Fällen erkannter Wandlersättigung einen zeitweise erhöhten Ladungs-Schwellenwert für die Entscheidung über das Vorliegen eines inneren Fehlers zu verwenden.

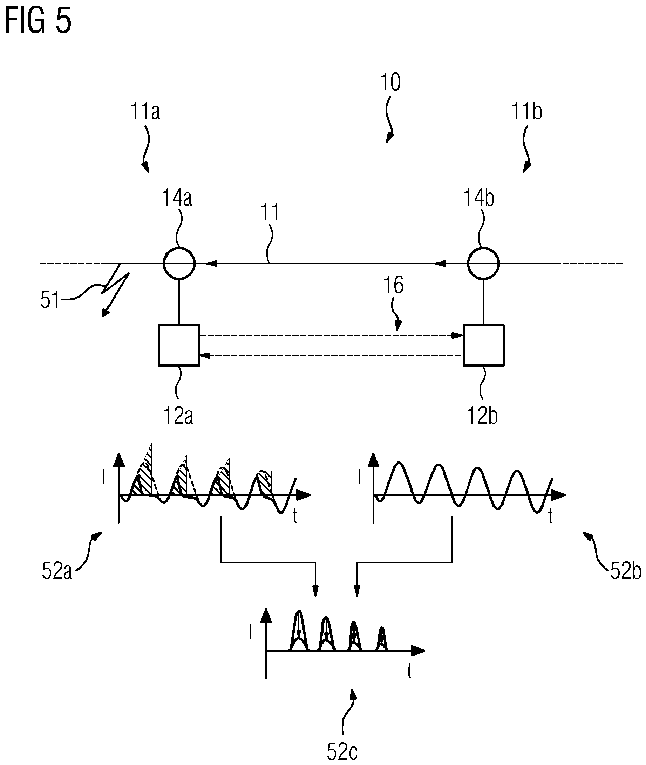

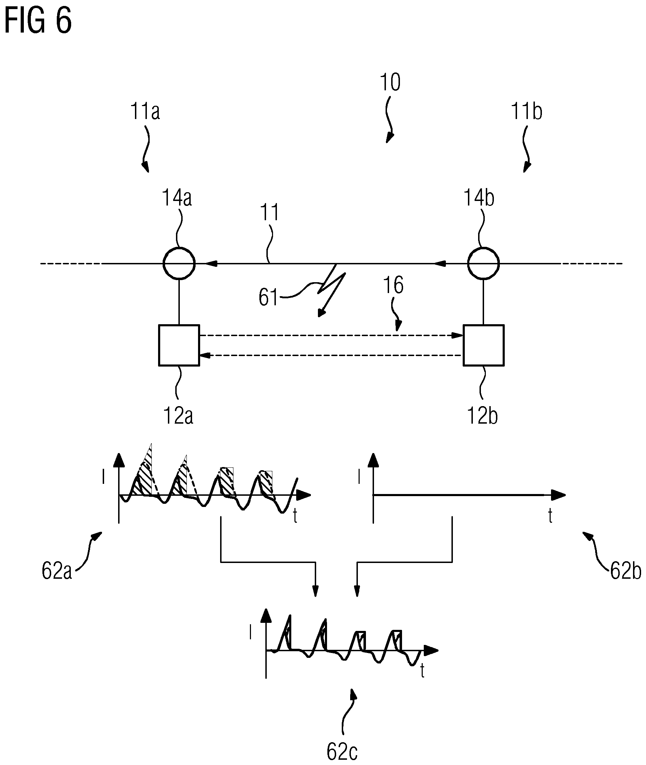

Figuren 5 und 6 zeigen das Differentialschutzsystem der Figuren 1 und 2 für die Fälle eines äußeren Fehlers 51 (Figur 5) und eines inneren Fehlers 61 (Figur 6). Es sei jeweils wieder eine Stromwandlersättigung des Stromwandlers 14a angenommen.

In Figur 5 sind Stromverläufe der Stromwandler 14a, 14b in Diagrammen 52a, 52b dargestellt. Der Verlauf des Differenzstroms ist in Diagramm 52c angedeutet. Bei vorliegenden äußeren Fehlern ergibt sich durch die Verwendung des Ladungs-Schätzwertes (vgl. Diagramm 52a) eine deutliche Reduzierung der Differenzladung (im Diagramm 52c durch Pfeile angedeutet), womit die Wahrscheinlichkeit einer Fehlauslösung stark minimiert wird.

In Figur 6 sind Stromverläufe der Stromwandler 14a, 14b in Diagrammen 62a, 62b dargestellt. Der Verlauf des Differenzstroms ist in Diagramm 62c angedeutet. Bei vorliegenden inneren Fehlern ergibt sich durch die Verwendung des Ladungs-Schätzwertes (vgl. Diagramm 62a) eine deutliche Erhöhung der Differenzladung (im Diagramm 62c durch Pfeile angedeutet), womit die Wahrscheinlichkeit der Erkennung des inneren Fehlers erhöht wird.

Der verwendete Ladungs-Schwellenwert kann als separater Parameter oder als Kennlinie in einem Auslösediagramm festgelegt sein.

Obwohl gemäß den Figuren 1, 2, 5 und 6 eine Leitung 11 mit lediglich zwei Enden 11a bzw. 11b gezeigt ist, kann das erfinderische Verfahren auch bei beliebigen ein- oder mehrphasigen Leitungen mit zwei oder mehr Enden, beispielsweise elektrischen Sammelschienen mit mehreren Abzweigen, eingesetzt werden.

Außerdem kann in Abweichung zur Darstellung gemäß Figur 1 auch vorgesehen sein, dass die Strommesswerte zu einer einzigen Differentialschutzeinrichtung übertragen und dort ausgewertet werden. In diesem Fall reicht es aus, an den Enden 11a, 11b der Leitung 11 Messeinrichtungen zu platzieren, die die Strommesswerte erfassen und an die Differentialschutzeinrichtung übermitteln. Diese Differentialschutzeinrichtung könnte an einem der Leitungsenden, aber auch an beliebiger anderer Stelle, beispielsweise als zentrale Differentialschutzeinrichtung in einer Schaltanlagenstation oder einer Leitstelle, angeordnet sein.

Bei dem beschriebenen Differentialschutzverfahren wird somit quasi eine verlorene Information über den Verlauf des Stromsignals nach Eintritt der Stromwandlersättigung auf sehr einfache Art und Weise zurückgewonnen, so dass Maßnahmen zur übermäßigen Stabilisierung gegen Messfehler bis hin zur Blockierung der Messung vermieden werden können.

Das beschriebene Verfahren benutzt mit anderen Worten das zeitliche Stromintegral anstatt die Momentanwerte oder Zeiger der Ströme. Erfindungsgemäß wird das zeitliche Stromintegral nicht durch die Rekonstruktion der einzelnen Momentanwerte, sondern durch eine gleichwertige Äquivalenzfläche gewonnen. Da diese Äquivalenzfläche, bedingt durch ihre Einfachheit fehlerbehaftet ist, wird sie mit einem entsprechend höheren Stabilisierungsbeitrag bewertet.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Differentialschutzverfahren zum Überwachen einer Leitung (11) eines elektrischen Energieversorgungsnetzes, bei dem

   - an den Enden (11a, 11b) der Leitung (11) mit induktiven Stromwandlern (14a, 14b) Stromsignale erzeugt werden, die zu einem an dem jeweiligen Ende (11a, 11b) fließenden Strom proportional sind;
   - für jedes Ende (11a, 11b) mit Messeinrichtungen aus dem jeweiligen Stromsignal Strommesswerte gebildet werden, die einen Verlauf des an dem jeweiligen Ende (11a, 11b) fließenden Stroms angeben;
   - aus den Strommesswerten für jedes Ende ein jeweiliger Ladungswert bestimmt wird;
   - die Ladungswerte aller Enden (11a, 11b) vorzeichenrichtig unter Bildung einer Ladungssumme aufsummiert werden; und
   - ein einen internen Fehler auf der Leitung (11) angebendes Fehlersignal erzeugt wird, wenn die Ladungssumme einen Ladungs-Schwellenwert übersteigt;

   **dadurch gekennzeichnet, dass**

   - bei vorliegender Wandlersättigung eines Stromwandlers mit der entsprechenden Messeinrichtung ein Ladungs-Schätzwert ermittelt wird; und
   - der Ladungs-Schätzwert anstelle des durch Wandlersättigung verfälschten Ladungswertes zur Bildung der Ladungssumme verwendet wird.

2. Verfahren nach Anspruch 1,
   **dadurch gekennzeichnet, dass**

   - zur Bildung des jeweiligen Ladungswertes während eines vorgegebenen Zeitintervalls ein zeitliches Integral über die Strommesswerte des jeweiligen Endes (11a, 11b) der Leitung (11) gebildet wird.

3. Verfahren nach Anspruch 2,
   **dadurch gekennzeichnet, dass**

   - der Ladungs-Schätzwert unter Verwendung zumindest eines zum Eintrittszeitpunkt der Wandlersättigung vorliegenden Strommesswertes ermittelt wird.

4. Verfahren nach Anspruch 3,
   **dadurch gekennzeichnet, dass**

   - zur Ermittlung des Ladungs-Schätzwertes eine zum einen durch den Strommesswert zum Eintrittszeitpunkt der Wandlersättigung und zum anderen durch den letzten Nulldurchgang des Stromverlaufs gehende Gerade (35) bestimmt wird; und
   - der Ladungs-Schätzwert als innerhalb des Zeitintervalls zwischen der Geraden (35) und der Nulllinie liegende Fläche bestimmt wird.

5. Verfahren nach Anspruch 3,
   **dadurch gekennzeichnet, dass**

   - zur Ermittlung des Ladungs-Schätzwertes ein Rechteck (45) gebildet wird, dessen eine Seite durch den Strommesswert zum Eintrittszeitpunkt der Wandlersättigung und dessen andere Seite durch die Dauer des Zeitintervalls bestimmt wird; und
   - der Ladungs-Schätzwert als Fläche des Rechtecks (45) bestimmt wird.

**6.** Verfahren nach einem der Ansprüche 3 bis 5, **dadurch gekennzeichnet, dass**

- zur Erkennung des Eintrittszeitpunkts der Wandlersättigung ein Differenzwert zwischen einem aktuellen Strommesswert und einem Vorhersagewert bestimmt wird, wobei der Vorhersagewert einen erwarteten Verlauf des Stromes angibt; und
- der Eintrittszeitpunkt dann erkannt wird, wenn der Differenzwert einen Sättigungs-Schwellenwert überschreitet.

**7.** Verfahren nach einem der vorigen Ansprüche,

- bei vorliegender Wandlersättigung der Ladungs-Schwellenwert zeitweise erhöht wird.

**8.** Differentialschutzeinrichtung (12a) zum Überwachen einer Leitung (11) eines elektrischen Energieversorgungsnetzes mit

- einer Messeinrichtung, die zum Erfassen eines an einem Ende (11a) der Leitung (11) erzeugten Stromsignals und zur Bildung von Strommesswerten, die einen Verlauf eines an dem jeweiligen Ende (11a) fließenden Stroms angeben, eingerichtet ist, wobei das Stromsignal mit einem induktiven Stromwandler (14a) proportional zu einem an dem Ende fließenden Strom erzeugt worden ist; und
- einer Auswertungseinrichtung, die dazu eingerichtet ist, aus den Strommesswerten einen Ladungswert zu bestimmen, die Ladungswerte mit einem Ladungsmesswert mindestens einer anderen Differentialschutzeinrichtung (12b) vorzeichenrichtig unter Bildung einer Ladungssumme aufzusummieren und ein einen internen Fehler auf der Leitung (11) angebendes Fehlersignal zu erzeugen, wenn die Ladungssumme einen Ladungs-Schwellenwert übersteigt;

**dadurch gekennzeichnet, dass**

- die Auswertungseinrichtung dazu eingerichtet ist, bei vorliegender Wandlersättigung des Stromwandlers (14a) einen Ladungs-Schätzwert zu ermitteln und diesen anstelle des durch Wandlersättigung verfälschten Ladungswertes zur Bildung der Ladungssumme zu verwenden.

**9.** Differentialschutzsystem zum Überwachen einer Leitung (11) eines elektrischen Energieversorgungsnetzes, wobei die Leitung (11) mindestens zwei Enden (11a, 11b) aufweist und wobei an jedem Ende (11a, 11b) eine Differentialschutzeinrichtung gemäß Anspruch 8 angeordnet ist.

**Claims**

**1.** Differential protection method for monitoring a line (11) of an electrical energy supply network, in which method

- current signals are generated at the ends (11a, 11b) of the line (11) using inductive current transformers (14a, 14b), which current signals are proportional to a current flowing at the respective end (11a, 11b);
- for each end (11a, 11b), current measurement values are formed from the respective current signal using measuring devices, which current measurement values indicate a profile of the current flowing at the respective end (11a, 11b);
- for each end, a respective charge value is determined from the current measurement values;
- the charge values of all the ends (11a, 11b) are summed with the correct mathematical sign so as to form a charge sum; and
- a fault signal that indicates an internal fault on the line (11) is generated when the charge sum exceeds a charge threshold value;

**characterized in that**

- an estimated charge value is determined using the corresponding measuring device when transformer saturation of a current transformer is present; and
- the estimated charge value is used, instead of the charge value distorted by transformer saturation, to form the charge sum.

**2.** Method according to Claim 1, **characterized in that**

- a temporal integral over the current measurement values of the respective end (11a, 11b) of the line (11) is formed during a prescribed time interval to form the respective charge value.

**3.** Method according to Claim 2, **characterized in that**

- the estimated charge value is determined using at least one current measurement value present at the onset time of the transformer saturation.

**4.** Method according to Claim 3, **characterized in that**

- a straight line (35) that passes on the one hand through the current measurement value at the onset time of the transformer saturation and on the other hand through the last zero crossing of the current profile is determined to ascertain the estimated charge value; and
- the estimated charge value is determined as the area lying within the time interval between the straight line (35) and the zero line.

5. Method according to Claim 3,
**characterized in that**

- a rectangle (45) is formed to ascertain the estimated charge value, one side of which rectangle is determined by the current measurement value at the onset time of the transformer saturation and the other side of which rectangle is determined by the duration of the time interval; and
- the estimated charge value is determined as the area of the rectangle (45).

6. Method according to one of Claims 3 to 5,
**characterized in that**

- a difference value between a present current measurement value and a predicted value is determined to identify the onset time of the transformer saturation, wherein the predicted value indicates an expected profile of the current; and
- the onset time is identified when the difference value exceeds a saturation threshold value.

7. Method according to one of the preceding claims,

- the charge threshold value is temporarily increased when transformer saturation is present.

8. Differential protective device (12a) for monitoring a line (11) of an electrical energy supply network, said differential protective device having

- a measuring device which is configured to detect a current signal generated at an end (11a) of the line (11) and to form current measurement values which indicate a profile of a current flowing at the respective end (11a), wherein the current signal has been produced proportionally to a current flowing at the end using an inductive current transformer (14a); and
- an evaluation device which is configured to determine a charge value from the current measurement values, to sum the charge values with a charge measurement value of at least one other differential protective device (12b) with the correct mathematical sign so as to form a charge sum and to generate a fault signal that indicates an internal fault on the line (11) when the charge sum exceeds a charge threshold value;

**characterized in that**

- the evaluation device is configured, when transformer saturation of the current transformer (14a) is present, to ascertain an estimated charge value and to use said estimated charge value, instead of the charge value distorted by transformer saturation, to form the charge sum.

9. Differential protective system for monitoring a line (11) of an electrical energy supply network, wherein the line (11) has at least two ends (11a, 11b), and wherein a differential protective device according to Claim 8 is arranged at each end (11a, 11b).

**Revendications**

1. Procédé de protection différentielle pour le contrôle d'une ligne (11) d'un réseau d'alimentation en énergie électrique, dans lequel

- on produit aux bouts (11a, 11b) de la ligne (11), par des transformateurs (14a, 14b) de courant, des signaux de courant, qui sont proportionnels à un courant passant au bout (11a, 11b) respectif ;
- pour chaque bout (11a, 11b) on forme, par des dispositifs de mesure, à partir du signal de courant respectif, des valeurs de mesure de courant, qui indiquent une courbe du courant passant au bout (11a, 11b) respectif ;
- à partir des valeurs de mesure de courant, on détermine, pour chaque bout, une valeur de charge respective ;
- on somme les valeurs de charge de tous les bouts (11a, 11b), d'une manière correcte en signe, avec formation d'une somme de charge ; et
- on produit un signal de défaut indiquant un défaut interne sur la ligne (11), si la somme de charge dépasse une valeur de seuil de charge ;

**caractérisé en ce que**

- en présence d'une saturation d'un transformateur de courant, on détermine une valeur estimative de charge par le dispositif de mesure correspondant ; et
- on utilise, pour former la somme de charge, la valeur estimative de charge au lieu de la valeur de charge faussée par la saturation du transformateur.

2. Procédé suivant la revendication 1,
**caractérisé en ce que**

- pour former la valeur de charge respective, on forme, pendant un intervalle de temps donné à l'avance, une intégrale en fonction du temps sur les valeurs de mesure du courant du bout (11a, 11b) respectif de la ligne (11).

**3.** Procédé suivant la revendication 2, **caractérisé en ce qu'**

- on détermine la valeur estimative de charge en utilisant au moins une valeur de mesure du courant présente à l'instant d'apparition de la saturation du convertisseur.

**4.** Procédé suivant la revendication 3, **caractérisé en ce que**

- pour déterminer la valeur estimative de charge, on détermine une droite (35) passant, d'une part, par la valeur de mesure du courant à l'instant où le convertisseur entre en saturation et, d'autre part, par le dernier passage par zéro de la courbe du courant ; et
- on détermine la valeur estimative de charge comme surface dans l'intervalle de temps entre la droite (35) et la ligne zéro.

**5.** Procédé suivant la revendication 3, **caractérisé en ce que**

- pour déterminer la valeur estimative de charge, on forme un rectangle (45), dont un côté est défini par la valeur de mesure du courant à l'instant d'apparition de la saturation du convertisseur et son autre côté par la durée de l'intervalle du temps ; et
- on détermine la valeur estimative de charge comme surface du rectangle (45).

**6.** Procédé suivant l'une des revendications 3 à 5, **caractérisé en ce que**

- pour détecter l'instant où le convertisseur entre en saturation, on détermine une valeur de différence entre une valeur de mesure du courant instantanée et une valeur prédite, la valeur prédite indiquant une courbe escomptée du courant ; et
- on détecte l'instant d'apparition, lorsque la valeur de différence dépasse une valeur de seuil de saturation.

**7.** Procédé suivant l'une des revendications précédentes,

- en présence d'une saturation du convertisseur, on augmente de temps en temps la valeur de seuil de charge.

**8.** Dispositif (12a) de protection différentielle pour le contrôle d'une ligne (11) d'un réseau d'alimentation en énergie électrique, comprenant

- un dispositif de mesure, qui est conçu pour la détection d'un signal de courant produit à un bout (11a) de la ligne (11) et pour la formation de valeurs de mesure de courant, qui indiquent une courbe d'un courant passant au bout (11a) respectif, dans lequel le signal de courant a été, par un transformateur (14a) de courant inductif, produit proportionnellement à un courant passant au bout ; et
- un dispositif d'analyse, qui est conçu pour déterminer, à partir des valeurs de mesure du courant, une valeur de charge, faire la somme des valeurs de charge avec une valeur de mesure de charge d'au moins un autre dispositif (12b) de protection différentielle, d'une manière correcte en signe, avec formation d'une somme de charge et produire un signal de défaut indiquant un défaut interne sur la ligne (11), si la somme de charge dépasse une valeur de seuil de charge ;

**caractérisé en ce que**

- le dispositif d'analyse est conçu pour, en présence d'une saturation du transformateur (14a) de courant, déterminer une valeur estimative de charge et utiliser celle-ci au lieu de la valeur de charge faussée par la saturation du convertisseur, pour forme la somme de charge.

**9.** Système de protection différentielle pour le contrôle d'une ligne (11) d'un réseau d'alimentation en énergie électrique, dans lequel la ligne (11) a au moins deux bouts (11a, 11b) et dans lequel un dispositif de protection différentielle est monté à chaque bout (11a, 11b).

FIG 1

# FIG 2

FIG 3

FIG 4

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19959776 A1
- US 7103485 B2
- WO 2008145694 A1
- DE 19928192 A1
- EP 0688078 A2
- US 6501631 B1